(19)

**Europäisches Patentamt**
**European Patent Office**
**Office européen des brevets**

(11)  **EP 4 686 951 A1**

(12)  **EUROPEAN PATENT APPLICATION**

(43) Date of publication:
**04.02.2026  Bulletin 2026/06**

(21) Application number: **25192871.9**

(22) Date of filing: **30.07.2025**

(51) International Patent Classification (IPC):
**G01R 31/26** (2020.01)     **G01R 31/327** (2006.01)

(52) Cooperative Patent Classification (CPC):
**G01R 31/3277; G01R 31/2608; G01R 31/2621;**
**G01R 31/2642; H03K 17/18;** G01R 31/2817;
H03K 2217/0027

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority:  **31.07.2024  IN 202411057928**

(71) Applicant: **Eaton Intelligent Power Limited**
**Dublin 4, D04 Y0C2 (IE)**

(72) Inventors:
• **SHARMA, Ambuj**
**Dublin, D04 Y0C2 (IE)**
• **UPADHYAY, Parth**
**Dublin, D04 Y0C2 (IE)**
• **SATSAI, Srinivas Mallampalli**
**Dublin, D04 Y0C2 (IE)**

(74) Representative: **Derry, Paul Stefan et al**
**Venner Shipley LLP**
**200 Aldersgate**
**London EC1A 4HD (GB)**

(54)  **HEALTH MONITORING OF A SWITCH**

(57)     A method for determining a remaining useful life of a switch (104) is provided. A position of a switch (104) in a converter (116) is determined. A switching sequence for the converter (116) is determined based on the position of the switch (104). The converter (116) is operated based on the determined switching sequence. An ON-state voltage across collector and emitter of the switch (104) is measured. A remaining useful life of the switch (104) is determined based on the measured ON-state voltage across collector and emitter.

FIG. 1

First Controller
152

Second Controller
154

EP 4 686 951 A1

**Description**

**Technical Field**

The present disclosure relates generally to health monitoring and failure prognosis of power electronics equipment, such as power converters, and more specifically, health monitoring and failure prognosis of a switch, such as Insulated-Gate Bipolar transistors (IGBTs) within power electronics equipment.

**Background**

Power semiconductor devices such as Insulated-Gate Bipolar Transistors (IGBTs) play an important role in various applications such as renewable energy, aerospace and marine drive systems, to achieve efficient electric energy conversion and to attain high performance of the systems. IGBTs are also one of the most fragile parts in power converters, and the reliability of the system is therefore heavily reliant on the non-failure of the semiconductor device. Power converters may be employed in safety critical applications such as starter generators, e-oil, e-fuel or electrical actuation systems in aerospace applications. In such applications, safety and reliability are of the upmost importance. IGBTs failure may happen due to over-voltage, over current, in-appropriate gate signals, IGBT die degradation, etc.

**Summary**

In accordance with some aspects of the present disclosure, a method for determining a remaining useful life of a power switch. A position of a switch in a converter is determined. A switching sequence for the converter is determined based on the position of the switch. The converter is operated based on the determined switching sequence. An ON-state voltage across collector and emitter of the switch is measured. A remaining useful life of the switch is determined based on the measured ON-state voltage across collector and emitter.

**Brief Description of the Drawings**

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.

FIG. 1 is a system for determining a remaining useful life of a switch.

FIG. 2 is a diagram illustrating parasitic capacitors of an Insulated-Gate Bipolar Transistors (IGBTs).

FIG. 3 is a diagram illustrates plots of a procedure to increase the sampling rate.

FIG. 4 is a flow diagram of a method for determining a remaining useful lifer of a switch.

FIG. 5 is a diagram of a computing device.

**Detailed Description**

In the following Detailed Description, reference is made to the accompanying drawings, which form a part hereof, and in which is shown by way of illustration specific embodiments in which the invention may be practiced. In this regard, directional terminology, such as top, bottom, front, back, etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense.

The disclosure provides off-line processes for health monitoring of a switch, for example, an Insulated-Gate Bipolar Transistor (IGBT) implemented on a three-phase converter. The proposed health monitoring is performed offline with a limited sampling rate of a low fidelity device. In one example, a change in an ON-state voltage across collector and emitter ($V_{CE\_ON}$) of an IGBT is measured. A Remaining Useful Life (RUL) of the IGBT is determined from the $V_{CE\_ON}$.

The $V_{CE\_ON}$ for the IGBT is measured by operating the converter incorporating the IGBT in a modified switching sequence. The modified switching sequence is determined based on a relative position of the IGBT with respect to a power source and other IGBTs in the converter. The modified switching sequence enables achieving a high accuracy of the $V_{CE\_ON}$ sensing without change in an existing architecture of the converter. The modified switching sequence further eliminates effects of IGBT's junction capacitance. The disclosure further provides processes to mitigate or eliminate the effect of noise over signal to keep minimum desired error with limited sampling rate. Moreover, processes provide for selection of IGBT's optimum operating point to measure $V_{CE\_ON}$ to achieve repeatability, precision, and accuracy. Although, the processes of the disclosure are being described referencing to an IGBT and a converter, the disclosed process can be used to determine a RUL of other types of switches (for example, diodes, Wide band Gap (WBG) switch, (WBJBJTs, MOSFETs, etc.) implemented on different types of circuits.

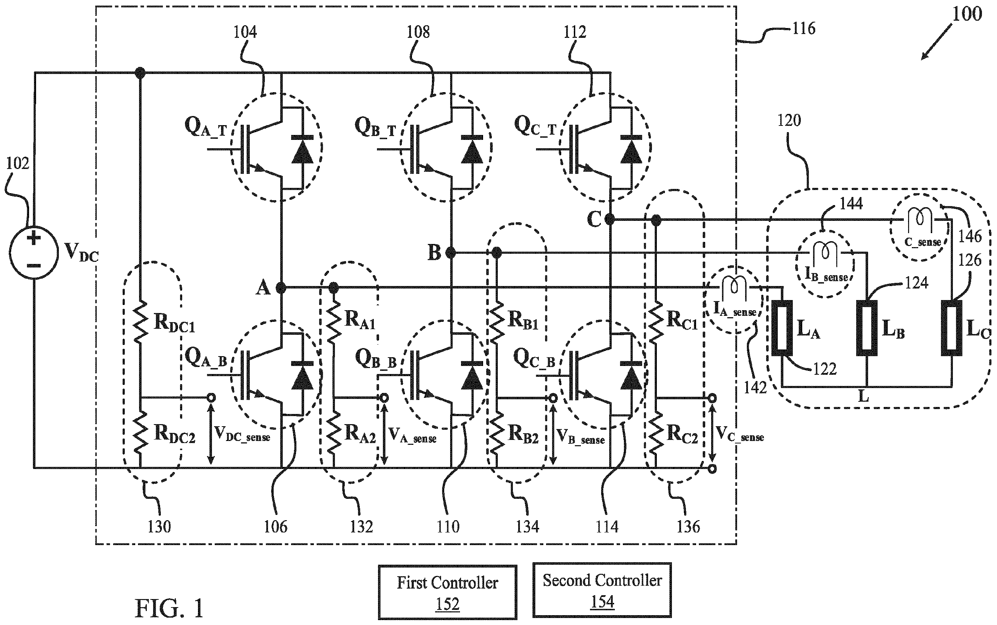

FIG. 1 is a system 100 for determining a remaining life of an IGBT implemented on a three-phase converter. In one example, system 100 may be associated with a fuel pump for an aircraft. As shown in FIG. 1, system 100 includes a power source 102. In examples, power source 102 can be a Direct Current (DC) power source providing a predetermined DC voltage (that is, $V_{DC}$) across its terminals. The $V_{DC}$ can be 100V, 520V, etc.

System 100 further includes a plurality of IGBTs, for example, a first IGBT ($Q_{A\_T}$) 104, a second IGBT ($Q_{A\_B}$) 106, a third IGBT ($Q_{B\_T}$) 108, a fourth IGBT ($Q_{B\_B}$) 110, a fifth IGBT ($Q_{Q\_T}$) 112, and a sixth IGBT ($Q_{C\_B}$) 114. The plurality of IGBTs are interconnected to form a converter 116. For example, a first terminal of first IGBT ($Q_{A\_T}$) 104 is connected to a first terminal (that is, a positive terminal) of power source 102 and a second terminal of first IGBT ($Q_{A\_T}$) 104 is connected to a first internal node A. A first terminal of second IGBT ($Q_{A\_B}$) 106 is connected to the first internal node A and a second terminal of second IGBT ($Q_{A\_B}$) 106 is connected to a second terminal (that is, a negative terminal) of power source 102. A first terminal of third IGBT ($Q_{B\_T}$) 108 is connected to the first terminal of power source 102 and a second terminal of third IGBT ($Q_{B\_T}$) 108 is connected to a second internal node B. A first terminal of fourth IGBT ($Q_{B\_B}$) 110 is connected to the second internal node B and a second terminal of fourth IGBT ($Q_{B\_B}$) 110 is connected to the second terminal of power source 102. A first terminal of fifth IGBT ($Q_{C\_T}$) 112 is connected to the first terminal of power source 102 and a second terminal of fifth IGBT ($Q_{C\_T}$) 112 is connected to a first internal node C. A first terminal of sixth IGBT ($Q_{C\_B}$) 114 is connected to the third internal node C and a second terminal of sixth IGBT ($Q_{C\_B}$) 114 is connected to the second terminal of power source 102.

First IGBT ($Q_{A\_T}$) 104 and second IGBT ($Q_{A\_B}$) 106 together may form a first phase or an A-phase of converter 116. Third IGBT ($Q_{B\_T}$) 108 and fourth IGBT ($Q_{B\_B}$) 110 together may form a second phase or a B-phase of converter 116. Fifth IGBT ($Q_{C\_T}$) 112 and sixth IGBT ($Q_{C\_B}$) 114 together may form a third phase or a C-phase of converter 116. In some examples, first IGBT ($Q_{A\_T}$) 104, a third IGBT ($Q_{B\_T}$) 108, and a fifth IGBT ($Q_{C\_T}$) 112 are also be referred to as top IGBTs as they are connected to the positive terminal of power source 102. In addition, second IGBT ($Q_{A\_B}$) 106, a fourth IGBT ($Q_{B\_B}$) 110, and sixth IGBT ($Q_{C\_B}$) 114 are also be referred to as bottom IGBTs as they are connected to the negative terminal of power source 102.

Converter 116 converts the DC power from power source 102 to an Alternate Current (AC) power and provides the AC power at the internal nodes A, B, and C. A load 120 may be connected to the internal nodes A, B, C. Load 120 may be a motor and hence an inductive load. For example, and as shown in FIG. 1, load 120 includes a first inductor ($L_A$) 122, a second inductor ($L_B$) 124, and a third indictor (Lc) 126. A first terminal of first inductor ($L_A$) 122 is connected to the first internal node A and a second terminal of first inductor ($L_A$) 122 is connected to a load node L. A first terminal of second inductor ($L_B$) 124 is connected to the second internal node B and a second terminal of second inductor ($L_B$) 122 is connected to the load node L. A first terminal of third inductor ($L_C$) 126 is connected to the third internal node C and a second terminal of third inductor ($L_C$) 126 is connected to the load node L. In some examples, first inductor ($L_A$) 122, second inductor ($L_B$) 124, and third indictor ($L_C$) 126 may represent three windings of a three-phase motor.

System 100 further includes a plurality of sensors, for example, a first voltage sensor 130, a second voltage sensor 132, a third voltage sensor 134, a fourth voltage sensor 136, a first current sensor 142, a second current sensor 144, and a third current sensor 146. In addition, system 100 may further include a first controller 152 and a second controller 154.

First voltage sensor 130 is configured to measure a voltage across terminals of power source 102. In one implementation, first voltage sensor 130 may include a first resistor $R_{DC1}$ and a second resister $R_{DC2}$ connected in series between the first terminal and the second terminal of power source 102. The voltage across terminals of power source ($V_{DC\_sense}$) is measured as the voltage across terminals of the second resistor $R_{DC2}$.

Second voltage sensor 132 is configured to measure a voltage at the first internal node A of converter 116. In one implementation, second voltage sensor 132 includes a first resistor $R_{A1}$ and a second resister $R_{A2}$ connected in series between the first internal node A and the second terminal of power source 102. The voltage of the first internal node A ($V_{A\_sense}$) is measured as the voltage across terminals of the second resistor $R_{A2}$.

Third voltage sensor 134 is configured to measure a voltage at the second internal node B of converter 116. In one implementation, third voltage sensor 134 includes a first resistor $R_{B1}$ and a second resister $R_{B2}$ connected in series between the second internal node B and the second terminal of power source 102. The voltage of the second internal node B ($V_{B\_sense}$) is measured as the voltage across terminals of the second resistor $R_{B2}$.

Fourth voltage sensor 136 is configured to measure a voltage at the third internal node C of converter 116. In one implementation, fourth voltage sensor 136 includes a first resistor $R_{C1}$ and a second resister $R_{C2}$ connected in series between the third internal node C and the second terminal of power source 102. The voltage of the third internal node C ($V_{C\_sense}$) is measured as the voltage across terminals of the second resistor $F_{C2}$.

First current sensor 142 is configured to measure an amount of current flowing through first inductor ($L_A$) 122. Second current sensor 144 is configured to measure an amount of current flowing through second inductor ($L_B$) 124. Third current sensor 146 is configured to measure an amount of current flowing through third inductor (Lc) 126.

First controller 152 is configured to control operations of converter 116. For example, first controller 152 is configured to trigger switching ON of the plurality of IGBTs of converter 116 to provide the AC power at the internal nodes A, B, and C or to load 120. First controller 152 may include a processing unit and a memory. The memory may store instructions which when executed by the processing unit performs steps of a method of controlling operations of converter 116.

Second controller 154 is configured to determine a RUL of one or more of the plurality of IGBTs of converter 116. For example, and as discussed in greater detail in the following sections of the disclosure, second controller 154 is configured to determine a switching sequence of one or more of the plurality of IGBTs of converter 116, receive measurements from the plurality of sensors, and determine the change in the $V_{CE\_ON}$ of one or more of the plurality of IGBTs to determine a RUL of the plurality of IGBTs and converter 116. Second controller 154 is further configured to increase an accuracy of the $V_{CE\_ON}$ sensing for an IGBT without changing an existing power architecture of converter 116. Second controller 154 is further configured to provide a switching scheme for eliminating effects of IGBT's junction capacitance during measurement of the $V_{CE\_ON}$. In addition, second controller 154 is configured to mitigate or eliminate the effect of noise over signal to keep minimum desired error with limited sampling rate for the $V_{CE\_ON}$. Moreover, second controller 154 is configured to provides for selection of IGBT's optimum operating point to measure the $V_{CE\_ON}$ to achieve repeatability, precision, and accuracy.

Second controller 154 may include a processing unit and a memory. The memory may store instructions which when executed by the processing unit performs steps of a determining a RUL for one or more of the plurality of IGBTs of converter 116. In some examples, first controller 152 and second controller 154 may be combined into a single controller. In some other examples, first controller 152 and second controller 154 may be referred to a microcontroller.

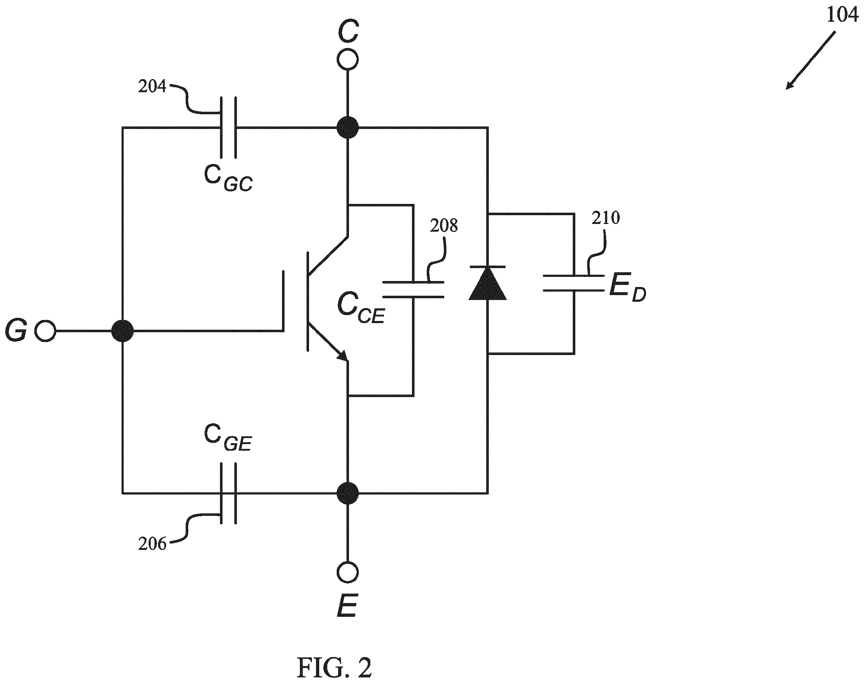

FIG. 2 is a diagram illustrating junction capacitors for an IGBT, for example, first IGBT ($Q_{A\_T}$) 104. First IGBT ($Q_{A\_T}$) 104 combines structures from both Metal Oxide Semiconductor Field Effect Transistors (MOSFETs) and Bipolar Junction Transistors (BJTs). For example, first IGBT ($Q_{A\_T}$) 104 is voltage controlled like a MOSFET while maintaining conduction characteristics and output switching of a transistor. First IGBT ($Q_{A\_T}$) 104 may include three terminals: a gate (G), a collector (C), and an emitter (E). A diode is connected between the emitter and the collector. The gate controls first IGBT ($Q_{A\_T}$) 104 while the collector and the emitter form a current and conductance path. For example, first IGBT ($Q_{A\_T}$) 104 may be switched ON by applying a positive gate voltage and switched OFF by making the gate voltage zero.

As shown in FIG. 2, first IGBT ($Q_{A\_T}$) 104 may have a plurality of parasitic junction capacitors, for example, a first junction capacitor ($C_{GC}$) 204 between the gate and the collector, a second junction capacitor ($C_{GE}$) 206 between the gate and the emitter, a third junction capacitor ($C_{CE}$) between the collector and the emitter, and a fourth junction capacitor ($C_D$) 210 between across the diode. These parasitic capacitors may appear because of structure of first IGBT ($Q_{A\_T}$) 104. Other IGBTs of converter 116 be similar to first IGBT ($Q_{A\_T}$) 104.

The junction capacitors of IGBTs may interfere with measurement of the ON-state voltage across collector and emitter ($V_{CE\_ON}$) with a normal switching scheme. The disclosure therefore provides a modified switching sequence for the IGBTs of converter 116 to determine the $V_{CE\_ON}$ of one or more of the plurality of IGBTs. The $V_{CE\_ON}$ for a top switch, for example, first IGBT ($Q_{A\_T}$) 104 may be measured as:

$$V_{CE\_ON} (Q_{A\_T}) = V_{DC\_sense} - V_{A\_sense}$$

where $V_{DC\_sense}$ is a voltage across terminals of the power source and $V_{A\_sense}$ is a voltage at the first internal node A. To measure the $V_{CE\_ON}$ for first IGBT ($Q_{A\_T}$) 104, the following switching sequence shown in Table 1 may be used:

Table 1

|        | A-Phase          | B-Phase     | C-Phase |
| ------ | ---------------- | ----------- | ------- |
| Top    | ON (Continuous)  | OFF         | OFF     |
| Bottom | OFF              | ON (Pulse)  | OFF     |

Thus, to measure the $V_{CE\_ON}$ for first IGBT ($Q_{A\_T}$) 104, which is a top IGBT of A-phase of converter 116, first IGBT ($Q_{A\_T}$) 104 is continuously kept ON by providing a continuous positive gating signal to the gate of first IGBT ($Q_{A\_T}$) 104. A return path for the current is provided by switching ON a bottom IGBT of another phase, for example, fourth IGBT ($Q_{B\_B}$)

110 of the B-phase or sixth IGBT ($Q_{C\_B}$) 114 of the C-phase through a pulse. In the switching sequence of Table 1, the return path is provided through fourth IGBT ($Q_{B\_B}$) 110 of the B-phase by applying a pulse gating signal to the gate of fourth IGBT ($Q_{B\_B}$) 110. The pulse gating signal may switch on fourth IGBT ($Q_{B\_B}$) 110 for a predetermined time which is long enough to measure the $V_{CE\_ON}$ for first IGBT ($Q_{A\_T}$) 104. Applying the pulse gating signal to the gate of fourth IGBT ($Q_{B\_B}$) 110 may result in lesser amount of power being used to measure the $V_{CE\_ON}$ for first IGBT ($Q_{A\_T}$) 104.

The modified switching sequences discussed above may leads to first IGBT ($Q_{A\_T}$) 104 being in fully operational state while negating effect of parasitic capacitance from fourth IGBT ($Q_{B\_B}$) 110. In addition, this switching sequence helps to avoid repeatability issues. A similar modified switching sequence may be used for other top switches, for example, third IGBT ($Q_{B\_T}$) 108 and fifth IGBT ($Q_{C\_T}$) 112.

The $V_{CE\_ON}$ for a bottom switch, for example, second IGBT ($Q_{A\_B}$) 106 may be measured as:

$$V_{CE\_ON}(Q_{B\_B}) = V_{B\_sense}$$

where $V_{B\_sense}$ is a voltage at the second internal node B. To measure the $V_{CE\_ON}$ for fourth IGBT ($Q_{B\_B}$) 110, the following switching sequence shown in Table 2 may be used:

Table 2

|  | A-Phase | B-Phase | C-Phase |
|---|---|---|---|
| Top | ON (Pulse) | OFF | OFF |
| Bottom | OFF | ON (Continuous) | OFF |

As shown in Table 2 above, to measure the $V_{CE\_ON}$ for fourth IGBT ($Q_{B\_B}$) 110, fourth IGBT ($Q_{B\_B}$) 104 is continuously kept ON by providing a continuous positive gating signal to the gate of fourth IGBT ($Q_{B\_B}$) 104. A return path for the current is provided by switching ON one of the top IGBTs from another phase, for example, first IGBT ($Q_{A\_T}$) 104 of the A-phase or fifth IGBT ($Q_{C\_T}$) 112 of the C-phase through a pulse. In the switching sequence of Table 2, the return path is provided through first IGBT ($Q_{A\_T}$) 104 of the A-phase by applying a pulse gating signal to the gate of first IGBT ($Q_{A\_T}$) 104. The pulse gating signal may switch on first IGBT ($Q_{A\_T}$) 104 for a predetermined time which is long enough to measure the $V_{CE\_ON}$ for fourth IGBT ($Q_{B\_B}$) 110. Applying the pulse gating signal to the gate of first IGBT ($Q_{A\_T}$) 104 may result in lesser amount of power being used to measure the $V_{CE\_ON}$ for fourth IGBT ($Q_{B\_B}$) 110.

The modified switching sequences discussed above may leads to fourth IGBT ($Q_{B\_B}$) 110 being in fully operational state while negating effect of parasitic capacitance from first IGBT ($Q_{A\_T}$) 104. In addition, this switching sequence helps to avoid repeatability issues. A similar modified switching sequence may be used for other bottom switches, for example, second IGBT ($Q_{A\_B}$) 106 and sixth IGBT ($Q_{C\_B}$) 114.

Usually, a range of IGBT's ON-state voltage is 0.8 V to 3.0 V. To get measurement accuracy in the range of +/- 2%, operating point of current in IGBT during ON-state may be selected in the range of 30% to 70% of its maximum rating. In addition, to avoid or minimize a junction temperature effect in the $V_{CE\_ON}$ measurement for any IGBT during ON-state, operating point of a current may be kept in the range of 30% of its maximum allowable rating.

In addition, first controller 152 and second controller 154 may operate at 3.0V with a of 25k sampling rate. Therefore, if the source voltage ($V_{DC}$) is 100V then a divider ratio of 34 is applied in first voltage sensor 130 to being the sensed voltage corresponding to power source 102 ($V_{DC\_sense}$) below 3.0V (that is, the operating voltage of second controller 154). Using the divider ratio of 34 brings the $V_{DC\_sense}$ to 2.94 V (that is, 100/34). The sensed voltage corresponding to the first internal node ($V_{A\_sense}$) may be 2.902V accounting for the drop in first IGBT ($Q_{A\_T}$) 104.

However, if the same divider ratio of 34 is used for measuring the voltage of the second internal node B, then the sensed voltage corresponding to the second internal node B ($V_{B\_Sense}$) may be 0.038V (that is, 1.3/34). This may lead to signal to noise ratio at $V_{B\_Sense}$ being low as the $V_{B\_sense}$ of 0.038V is close to the noise level of converter 116. Increase in the voltage of power source 102 may lead to further increase in the divider ratio, and therefore even lower signal to noise ration. For example, for a 520V power source 102, the divider ratio is 177 (that is, 520/3). At the divider ratio of 177, the $V_{B\_Sense}$ may drop down to 0.0073 V (that is, 1.3/177). This sensing voltage (that is, 0.0073 V or 7.3 mV) is comparable to a noise present in converter 116. Therefore, identifying an actual signal and noise at such low sensing voltage may become difficult.

The disclosure provides for the $V_{CE\_ON}$ measurement for a bottom switch using a unity voltage divider gain. The voltage divider gain for a bottom switch (that is, one of second IGBT ($Q_{A\_B}$) 106, a fourth IGBT ($Q_{B\_B}$) 110, and sixth IGBT ($Q_{C\_B}$) 114) is kept as:

$$\frac{V_{sense}}{V_A} = \frac{R_{A2}}{(RA_1 + RA_2)} = 1$$

To further mitigate the effect of the random noise from converter 116, the disclosure provides up-sampling approach with a sampling rate of 100K samples per seconds. In one example of the up-sampling approach, ten measurements are captured at a single operating point and then a mean value is used the RUL estimation.

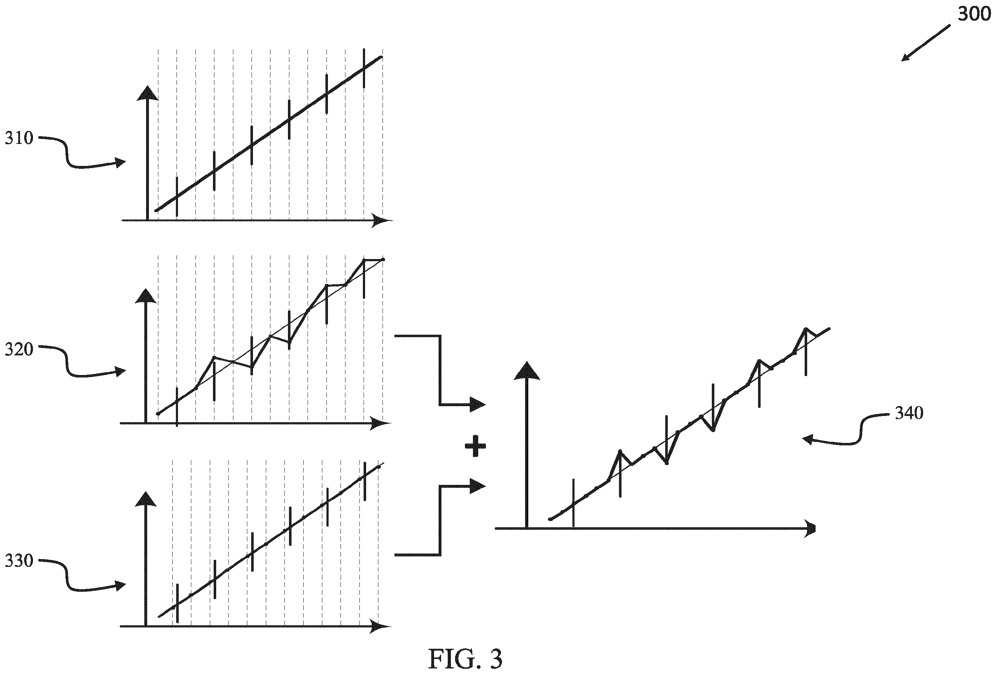

FIG. 3 illustrates plots of an example procedure to increase the sampling rate. For example, a first plot 310 of FIG. 3 illustrates an actual measurement of the $V_{CE\_ON}$. Second controller 154 may receive the actual measurement at a frequency of 25k signals per seconds. A band in first plot 310 shows an error that may happen due to noise at each measurement time. Second plot 320 illustrates a measured signal corresponding to first plot 310. More specifically, second plot 320 represents the measured signal with the noise level at every measurement point. Third plot 330 illustrate a time shifted measurement signal (that is, the actual measurement signal shifted by a predetermined time). The predetermined time can be determined based on a number of time shifts desired per measurement period. Time shifting of the measurement signal also increases a number of measurement signals available for measuring the $V_{CE\_ON}$. For example, ten measurement signals may be created for every measurement signal by time shifting the measurement signal by ten times.

Fourth plot 340 illustrates an average measurement signal of determined by averaging or determining a mean of the actual measurement signal of first plot 310 and time shifted measurement signal of third plot 330. As shown in fourth plot 340, the time shifting and averaging may reduce the effect of the random noise in the $V_{CE\_ON}$. For example, increasing the number of measurement signals decreases the effect of the random noise in the $V_{CE\_ON}$.

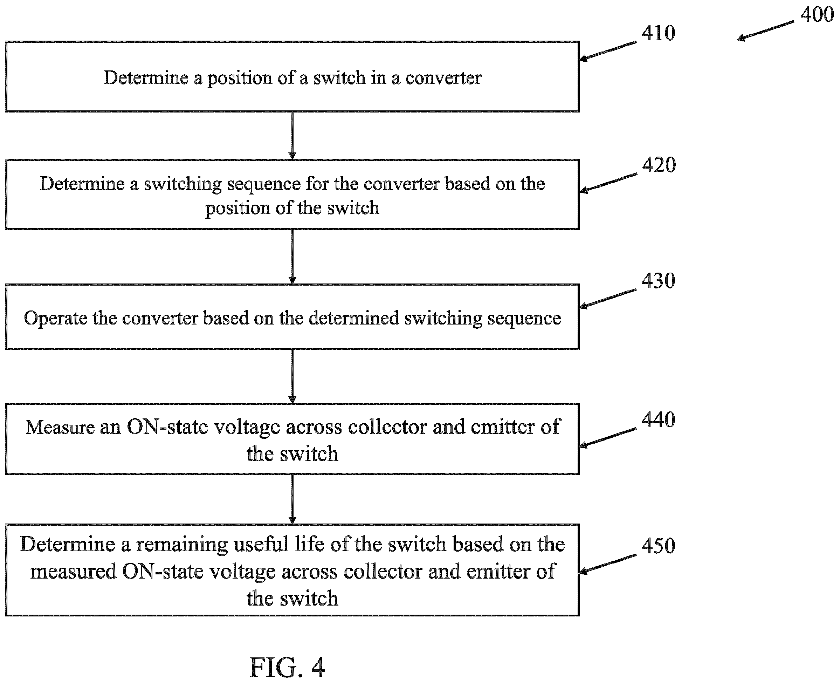

FIG. 4 is a flow chart of a method 400 for determining a RUL for a switch. Method 400 may be implemented using first controller 152 and second controller 154 as described in more detail above with respect to FIG. 1. Ways to implement the stages of method 400 will be described in greater detail below.

At stage 410 of method 400, position of a switch in converter 116 is determined. For example, if the RUL for first IGBT ($Q_{A\_T}$) 104 of converter 116 is to be determined, then the position of first IGBT ($Q_{A\_T}$) 104 is determined with respect to terminals of power source 102 and other switches of converter 116. For example, for first IGBT ($Q_{A\_T}$) 104, it may be determined that first IGBT ($Q_{A\_T}$) 104 is a top switch in the phase A of converter 116.

At stage 420 of method 400, a switching sequence for converter 116 is determined based on the position of the switch. For example, for first IGBT ($Q_{A\_T}$) 104, which is a top switch of the A-phase of converter 116, the switching sequence is defined in Table 1 and for fourth IGBT ($Q_{B\_B}$) 110, which is a bottom switch of the B-phase of converter 116, the switching sequence is defined in Table 2. As discussed above, the switching sequence for converter 116 is determined based on the position of the switch in converter 116.

At stage 430 of method 400, converter 116 is operated based on the determined switching sequence. First controller 152 may provide gating signals to the gates of the plurality of switches of converter 116 based on the determined switching sequence. For example, for the switching sequence provided in Table 1, first controller 152 provides a gating signal with a positive voltage to a gate of the first IGBT ($Q_{A\_T}$) 104, provides a gating signal of 0 voltage at gates of second IGBT ($Q_{A\_B}$) 106, third IGBT ($Q_{B\_T}$) 108, fifth IGBT ($Q_{C\_T}$) 112, and sixth IGBT ($Q_{C\_B}$) 114, and provides a pulse gating signal at the gate of fourth IGBT ($Q_{B\_B}$) 110.

At stage 440 of method 400, the ON-state voltage across collector and emitter ($V_{CE\_ON}$) of the power switch is measured. The $V_{CE\_ON}$ is measured using one of the plurality of voltage sensors of converter 116. As discussed above, the $V_{CE\_ON}$

At stage 450 of method 400, a RUL of the switch is determined based on the measured ON-state voltage across collector and emitter. For example, second controller 154 may receive the $V_{CE\_ON}$ and determine a change in the value of the $V_{CE\_ON}$. The change can be determined by comparing a current value with previous stored values. In some examples, a deviation in the value of the $V_{CE\_ON}$ may be determined over a predetermined number of values. The RUL of the switch is then determined based on the change or the deviation in the $V_{CE\_ON}$. Second controller 154 may identify degraded performance and predict RUL which may provide a significant advantage. For example, corrective measures may be taken before failure of converter 116.

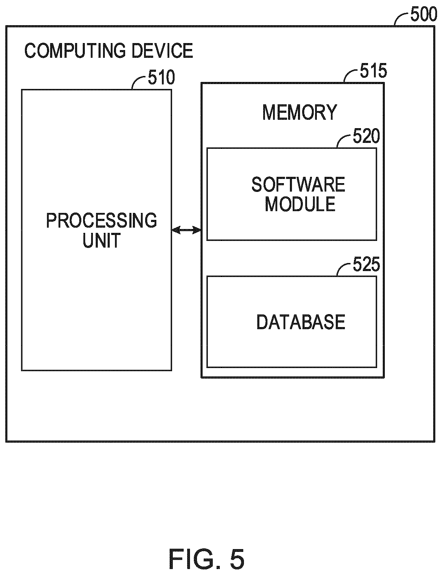

FIG. 5 shows computing device 500. As shown in FIG. 5, computing device 500 may include a processing unit 510 and a memory unit 515. Memory unit 515 may include a software module 520 and a database 525. While executing on processing unit 510, software module 520 may perform, for example, processes for determining RUL of an IGBT as described above with respect to FIG. 4. Computing device 500, for example, may provide an operating environment for first controller 152 and second controller 154. First controller 152 or second controller 154 may operate in other environments and are not limited to computing device 500.

Computing device 500 may be implemented using a Wi-Fi access point, a tablet device, a mobile device, a smart phone, a personal computer, a network computer, a mainframe, a router, a switch, a server cluster, a network storage device, a network relay device, or other similar microcomputer-based device. Computing device 500 may comprise any computer operating environment, such as hand-held devices, multiprocessor systems, microprocessor-based or programmable sender electronic devices, minicomputers, mainframe computers, and the like. Computing device 500 may also be practiced in distributed computing environments where tasks are performed by remote processing devices. The aforementioned systems and devices are examples, and computing device 500 may comprise other systems or devices.

Implementations of the disclosure, for example, may be implemented as a computer process (method), a computing system, or as an article of manufacture, such as a computer program product or computer readable media. The computer program product may be a computer storage media readable by a computer system and encoding a computer program of instructions for executing a computer process. The computer program product may also be a propagated signal on a carrier readable by a computing system and encoding a computer program of instructions for executing a computer process. Accordingly, the present disclosure may be embodied in hardware and/or in software (including firmware, resident software, micro-code, etc.). In other words, implementations of the present disclosure may take the form of a computer program product on a computer-usable or computer-readable storage medium having computer-usable or computer-readable program code embodied in the medium for use by or in connection with an instruction execution system. A computer-usable or computer-readable medium may be any medium that can contain, store, communicate, propagate, or transport the program for use by or in connection with the instruction execution system, apparatus, or device.

The computer-usable or computer-readable medium may be, for example but not limited to, an electronic, magnetic, optical, electromagnetic, infrared, or semiconductor system, apparatus, device, or propagation medium. More specific computer-readable medium examples (a non-exhaustive list), the computer-readable medium may include the following: an electrical connection having one or more wires, a portable computer diskette, a random access memory (RAM), a read-only memory (ROM), an erasable programmable read-only memory (EPROM or Flash memory), an optical fiber, and a portable compact disc read-only memory (CD-ROM). Note that the computer-usable or computer-readable medium could even be paper or another suitable medium upon which the program is printed, as the program can be electronically captured, via, for instance, optical scanning of the paper or other medium, then compiled, interpreted, or otherwise processed in a suitable manner, if necessary, and then stored in a computer memory.

While certain implementations of the disclosure have been described, other implementations may exist. Furthermore, although implementations of the present disclosure have been described as being associated with data stored in memory and other storage mediums, data can also be stored on or read from other types of computer-readable media, such as secondary storage devices, like hard disks, floppy disks, or a CD-ROM, a carrier wave from the Internet, or other forms of RAM or ROM. Further, the disclosed methods' stages may be modified in any manner, including by reordering stages and/or inserting or deleting stages, without departing from the disclosure.

Furthermore, implementations of the disclosure may be practiced in an electrical circuit comprising discrete electronic elements, packaged or integrated electronic chips containing logic gates, a circuit utilizing a microprocessor, or on a single chip containing electronic elements or microprocessors. Implementations of the disclosure may also be practiced using other technologies capable of performing logical operations such as, for example, AND, OR, and NOT, including but not limited to, mechanical, optical, fluidic, and quantum technologies. In addition, implementations of the disclosure may be practiced within a general purpose computer or in any other circuits or systems.

Implementations of the disclosure may be practiced via a system-on-a-chip (SOC) where each or many of the element illustrated in FIG. 1 may be integrated onto a single integrated circuit. Such an SOC device may include one or more processing units, graphics units, communications units, system virtualization units and various application functionality all of which may be integrated (or "burned") onto the chip substrate as a single integrated circuit. When operating via an SOC, the functionality described herein with respect to implementations of the disclosure, may be performed via application-specific logic integrated with other components of computing device 500 on the single integrated circuit (chip).

Implementations of the present disclosure, for example, are described above with reference to block diagrams and/or operational illustrations of methods, systems, and computer program products according to implementations of the disclosure. The functions/acts noted in the blocks may occur out of the order as shown in any flowchart. For example, two blocks shown in succession may in fact be executed substantially concurrently or the blocks may sometimes be executed in the reverse order, depending upon the functionality/acts involved.

While the specification includes examples, the disclosure's scope is indicated by the following claims. Furthermore, while the specification has been described in language specific to structural features and/or methodological acts, the claims are not limited to the features or acts described above. Rather, the specific features and acts described above are disclosed as example for implementations of the disclosure.

The following clauses form part of the description.

Clause 1. A method for determining a remaining useful life of a switch, the method comprising:

determining a position of a switch in a converter;
determining a switching sequence for the converter based on the position of the switch;
operating the converter based on the determined switching sequence;

measuring an ON-state voltage across collector and emitter of the switch; and
determining a remaining useful life of the switch based on the ON-state voltage across collector and emitter.

Clause 2. The method of clause 1, wherein determining the switching sequence for the converter based on the position of the switch comprises determining the switching sequence that provides a continuous gating signal to the switch and provides a pulse gating signal to another switch, the another switch being located in a different phase from that of the switch.

Clause 3. The method of clause 1, wherein measuring the ON-state voltage across collector and emitter of the switch comprising:
measuring the ON-state voltage across collector and emitter of the switch using a first divider ratio when the switch is a top switch.

Clause 4. The method of clause 1, wherein measuring the ON-state voltage across collector and emitter of the switch comprising:
measuring the ON-state voltage across collector and emitter of the switch using a divider ratio of one when the switch is a bottom switch.

Clause 5. The method of clause 1, further comprising:

determining a predetermined number of time shifted values for the ON-state voltage across collector and emitter of the switch; and
determining an average of the predetermined number of time shifted values for the ON-state voltage across collector and emitter of the switch.

Clause 6. The method of clause 1, wherein determining the remaining useful life of the switch based on the measured ON-state voltage across collector and emitter comprises:

determining a change in the measured ON-state voltage across collector and emitter from previous values; and
determining the remaining useful life of the switch based on the change in the measured ON-state voltage across collector and emitter.

Clause 7. The method of clause 1, wherein operating the converter based on the determined switching sequence comprises operating the switch of the converter in a range of 30% to 70% of its maximum rating.

Clause 8. The method of clause 1, further comprising:
mitigating a noise in the ON-state voltage across collector and emitter through up sampling.

Clause 9. The method of clause 1, wherein the switch comprises an Insulated-Gate Bipolar Transistor (IGBT).

Clause 10. A computing device comprising:

a memory storage; and
a processing unit coupled to the memory storage, wherein the processing unit is operative to:

determine a position of a switch in a converter;
determine a switching sequence for the converter based on the position of the switch;
operate the converter based on the determined switching sequence;
measure an ON-state voltage across collector and emitter of the switch; and
determine a remaining useful life of the switch based on the ON-state voltage across collector and emitter.

Clause 11. The system of clause 10, wherein the processing unit being configured to determine the switching sequence for the converter based on the position of the switch comprises the processing unit being configured to determine the switching sequence that provides a continuous gating signal to the switch and provides a pulse gating signal to another switch, the another switch being located in a different phase from that of the switch.

Clause 12. The system of clause 10, wherein the processing unit being configured to measure the ON-state voltage across collector and emitter of the switch comprises the processing unit being configured to:

measure the ON-state voltage across collector and emitter of the switch using a first divider ratio when the switch is a top switch.

Clause 13. The system of clause 10, wherein the processing unit being configured to measure the ON-state voltage across collector and emitter of the switch comprises the processing unit being configured to:
measure the ON-state voltage across collector and emitter of the switch using a divider ratio of one when the switch is a bottom switch.

Clause 14. The system of clause 10, wherein the processing unit is further configured to:

determine a predetermined number of time shifted values for the ON-state voltage across collector and emitter of the switch; and
determine an average of the predetermined number of time shifted values for the ON-state voltage across collector and emitter of the switch.

Clause 15. The system of clause 10, wherein the processing unit being configured to determine the remaining useful life of the switch based on the measured ON-state voltage across collector and emitter comprises the processing unit being configured to:

determine a change in the measured ON-state voltage across collector and emitter from previous values; and
determine the remaining useful life of the switch based on the change in the measured ON-state voltage across collector and emitter.

Clause 16. The system of clause 10, wherein the processing unit being configured to operate the converter based on the determined switching sequence comprises the processing unit being configured to operate the switch of the converter in a range of 30% to 70% of its maximum rating.

Clause 17. The system of clause 10, wherein the processing unit is further configured to:
mitigate a noise in the ON-state voltage across collector and emitter through up sampling.

Clause 18. The system of clause 10, wherein the switch comprises an Insulated-Gate Bipolar Transistor (IGBT).

Clause 19. A non-transitory computer-readable medium storing instructions that, when executed, causes a processor to perform operations, comprising:

determining a position of a switch in a converter;
determining a switching sequence for the converter based on the position of the switch;
operating the converter based on the determined switching sequence;
measuring an ON-state voltage across collector and emitter of the switch; and
determining a remaining useful life of the switch based on the ON-state voltage across collector and emitter.

Clause 20. The non-transitory computer-readable medium of clause 19, wherein determining the switching sequence for the converter based on the position of the switch comprises determining the switching sequence that provides a continuous gating signal to the switch and provides a pulse gating signal to another switch, the another switch being located in a different phase from that of the switch.

**Claims**

1. A method for determining a remaining useful life of a switch, the method comprising:

determining a position of a switch in a converter;
determining a switching sequence for the converter based on the position of the switch;
operating the converter based on the determined switching sequence;
measuring an ON-state voltage across collector and emitter of the switch; and
determining a remaining useful life of the switch based on the ON-state voltage across collector and emitter.

2. The method of claim 1, wherein determining the switching sequence for the converter based on the position of the switch comprises determining the switching sequence that provides a continuous gating signal to the switch and provides a pulse gating signal to another switch, the another switch being located in a different phase from that of the switch.

3. The method of claim 1 or claim 2, wherein measuring the ON-state voltage across collector and emitter of the switch comprising:
measuring the ON-state voltage across collector and emitter of the switch using a first divider ratio when the switch is a top switch.

4. The method of any preceding claim, wherein measuring the ON-state voltage across collector and emitter of the switch comprising:
measuring the ON-state voltage across collector and emitter of the switch using a second divider ratio of one when the switch is a bottom switch.

5. The method of any preceding claim, further comprising:

   determining a predetermined number of time shifted values for the ON-state voltage across collector and emitter of the switch; and
   determining an average of the predetermined number of time shifted values for the ON-state voltage across collector and emitter of the switch.

6. The method of any preceding claim, wherein determining the remaining useful life of the switch based on the measured ON-state voltage across collector and emitter comprises:

   determining a change in the measured ON-state voltage across collector and emitter from previous values; and
   determining the remaining useful life of the switch based on the change in the measured ON-state voltage across collector and emitter.

7. The method of any preceding claim, wherein operating the converter based on the determined switching sequence comprises operating the switch of the converter in a range of 30% to 70% of its maximum rating.

8. The method of any preceding claim, further comprising:
mitigating a noise in the ON-state voltage across collector and emitter through up sampling.

9. The method of any preceding claim, wherein the switch comprises an Insulated-Gate Bipolar Transistor (IGBT).

10. A computing device comprising:

    a memory storage; and
    a processing unit coupled to the memory storage, wherein the processing unit is operative to:

       determine a position of a switch in a converter;
       determine a switching sequence for the converter based on the position of the switch;
       operate the converter based on the determined switching sequence;
       measure an ON-state voltage across collector and emitter of the switch; and
       determine a remaining useful life of the switch based on the ON-state voltage across collector and emitter.

11. The system of claim 10, wherein the processing unit being configured to determine the switching sequence for the converter based on the position of the switch comprises the processing unit being configured to determine the switching sequence that provides a continuous gating signal to the switch and provides a pulse gating signal to another switch, the another switch being located in a different phase from that of the switch.

12. The system of claim 10 or claim 11, wherein the processing unit being configured to measure the ON-state voltage across collector and emitter of the switch comprises the processing unit being configured to:
measure the ON-state voltage across collector and emitter of the switch using a first divider ratio when the switch is a top switch or a second divider ratio of one when the switch is a bottom switch.

13. The system of any of claims 10 to 12, wherein the processing unit is further configured to:

determine a predetermined number of time shifted values for the ON-state voltage across collector and emitter of the switch; and

determine an average of the predetermined number of time shifted values for the ON-state voltage across collector and emitter of the switch.

14. The system of any of claims 10 to 13, wherein the processing unit being configured to determine the remaining useful life of the switch based on the measured ON-state voltage across collector and emitter comprises the processing unit being configured to:

determine a change in the measured ON-state voltage across collector and emitter from previous values; and

determine the remaining useful life of the switch based on the change in the measured ON-state voltage across collector and emitter.

15. A non-transitory computer-readable medium storing instructions that, when executed, causes a processor to perform a method of any of claims 1-9.

FIG. 1

First Controller
152

Second Controller
154

EP 4 686 951 A1

FIG. 2

FIG. 3

EP 4 686 951 A1

EP 4 686 951 A1

400

```
┌─────────────────────────────────────────────────────────────┐
│                                                              │  410
│         Determine a position of a switch in a converter      │
│                                                              │
└─────────────────────────────────────────────────────────────┘
                              │
                              ▼
┌─────────────────────────────────────────────────────────────┐
│   Determine a switching sequence for the converter based on the │  420
│                   position of the switch                     │
│                                                              │
└─────────────────────────────────────────────────────────────┘
                              │
                              ▼
┌─────────────────────────────────────────────────────────────┐
│                                                              │  430
│   Operate the converter based on the determined switching sequence │
│                                                              │
└─────────────────────────────────────────────────────────────┘
                              │
                              ▼
┌─────────────────────────────────────────────────────────────┐
│   Measure an ON-state voltage across collector and emitter of │  440
│                         the switch                           │
│                                                              │
└─────────────────────────────────────────────────────────────┘
                              │
                              ▼
┌─────────────────────────────────────────────────────────────┐
│  Determine a remaining useful life of the switch based on the │  450
│  measured ON-state voltage across collector and emitter of   │
│                         the switch                           │
└─────────────────────────────────────────────────────────────┘
```

FIG. 4

FIG. 5

Europäisches
Patentamt

European
Patent Office

Office européen
des brevets

## EUROPEAN SEARCH REPORT

**Application Number**

EP 25 19 2871

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 198 528 A1 (EATON INTELLIGENT POWER LTD [IE]) 21 June 2023 (2023-06-21) * paragraph [0007] - paragraph [0101]; figures 1-9 * ----- | 1-15 | INV. G01R31/26 G01R31/327 |
| X | US 2023/194593 A1 (SOMAYAJULA DEEPAK BALAJI [IN] ET AL) 22 June 2023 (2023-06-22) * figures 1-9 * * paragraph [0022] - paragraph [0178] * ----- | 1,10,15 | |

**TECHNICAL FIELDS SEARCHED (IPC)**

G01R
H03K

The present search report has been drawn up for all claims

| Place of search | Date of completion of the search | Examiner |
|---|---|---|
| Munich | 17 November 2025 | Sedlmaier, Stefan |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

...........................................................................

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 19 2871

This annex lists the patent family members relating to the patent documents cited in the above-mentioned European search report.
The members are as contained in the European Patent Office EDP file on
The European Patent Office is in no way liable for these particulars which are merely given for the purpose of information.

17-11-2025

| Patent document cited in search report | Publication date | Patent family member(s) | Publication date |
|---|---|---|---|
| EP 4198528 A1 | 21-06-2023 | NONE | |
| US 2023194593 A1 | 22-06-2023 | NONE | |

EPO FORM P0459

For more details about this annex : see Official Journal of the European Patent Office, No. 12/82